# EUROPEAN PATENT APPLICATION

(11) **EP 2 722 953 A1**
(43) Date of publication of application: **23.04.2014**
(21) Application number: 13186995.0
(22) Date of filing: 02.10.2013
(51) Int. Cl.: H02H 3/04, H01H 85/30, H03K 17/18

(54) **Method and apparatus for blown fuse detection**

(30) Priority: 15.10.2012 US 201213651681
(71) Applicant: Hamilton Sundstrand Corporation, Windsor Locks, CT 06096-1010 (US)
(72) Inventor: Buzzard, John N., Rockford, IL Illinois 61107 (US)
(74) Representative: Bridge, Kerry Ann

(57) **Abstract**

A blown fuse detector according to an exemplary aspect of the present disclosure includes, among other things a fuse, 28, and a resistor, 26, in series with a circuit breaker, 18. The circuit breaker, 18, and the resistor, 26, are in parallel with the fuse, 28, and the circuit breaker, 18, is configured to trip when the fuse, 28, blows.

## Description

### BACKGROUND

Generally, this disclosure relates to the field of electrical fuses. More particularly, this disclosure relates to a method and apparatus for detecting a blown fuse in an electrical system.

Various types of equipment include complicated electrical systems that incorporate fuses to protect the power source, the system load, or the system wiring from an overload or a short circuit. In the case of an overload or a short circuit to the electrical system, the fuse will fail or blow and interrupt the flow of current in the system to prevent damage to the power source, the system load, or the system wiring. Determining the status of these fuses is often difficult, especially during the maintenance and operation of the piece of equipment.

### SUMMARY

A blown fuse detector according to an exemplary aspect of the present disclosure includes, among other things, a fuse and a resistor in series with a circuit breaker. The circuit breaker and the resistor are in parallel with the fuse and the circuit breaker is configured to trip when the fuse blows.

A blown fuse detector assembly according to an exemplary aspect of the present disclosure includes, among other things, a power panel and at least one detection circuit in the power panel. The detection circuit includes a fuse and a resistor in series with a circuit breaker. The circuit breaker and the resistor are in parallel with the fuse and the circuit breaker is configured to trip when the fuse blows. The circuit breaker may contain an isolated auxiliary contact that indicates the state of the circuit breaker.

A method of assembling a blown fuse detector according to an exemplary aspect of the present disclosure includes, among other things, positioning a circuit breaker in series with a resistor and positioning a fuse in parallel with the circuit breaker and the resistor.

These and other features of the disclosed examples can be understood from the following description and the accompanying drawings, which can be briefly described as follows.

### BRIEF DESCRIPTION OF THE DRAWINGS

Figure 1 schematically illustrates an example power system.
Figure 2 schematically illustrates an example blown fuse detection circuit in the example power system of Figure 1.

### DETAILED DESCRIPTION

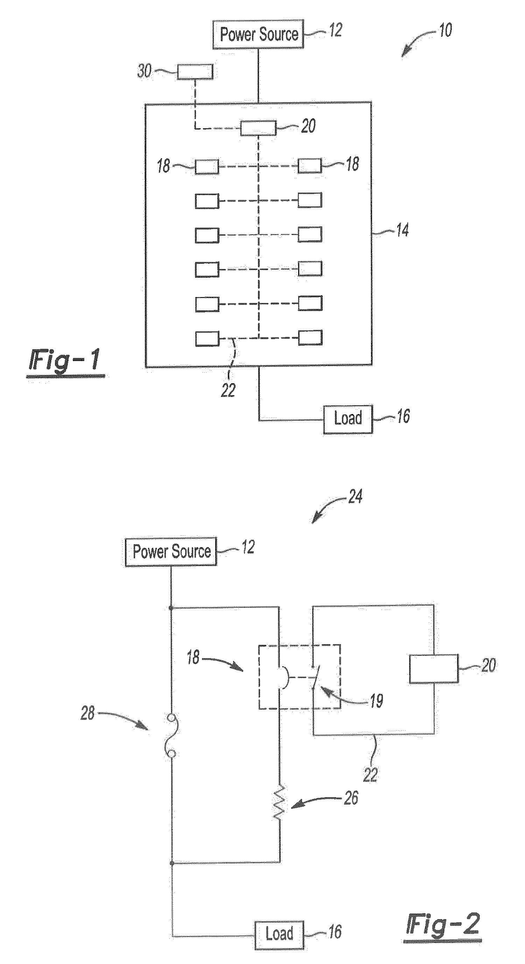

Figure 1 schematically illustrates an example power system 10 including a power source 12, a power panel 14, and a load 16. In this example, power source 12 includes a source bus bar and the load 16 includes a resistive component, such as an aircraft component or system wiring that receives power from the power source 12. The example power panel 14 includes circuit breakers 18 arranged in rows and columns that communicate with a circuit breaker position sensor 20 via an electrical connection 22. The circuit breakers 18 each move between an active position and a tripped position (i.e., an off position) in response to a load current. Each circuit breaker 18 includes an isolated auxiliary contact 19 that indicates the position of the circuit breaker 18 (shown in FIG. 2). The circuit breaker position sensor 20 determines if the circuit breaker 18 is in an active position or a tripped position by monitoring the isolated auxiliary contact 19 and relays the circuit breaker position information to a remote location 30, such as an aircraft cockpit, a maintenance facility, or a mobile device. The circuit breaker position sensor 20 may communicate with the remote location 30 via a wireless connection or a hard wired connection, such as an airplane data bus.

In some cases, fuses are used in place of circuit breakers for protection. Some fuses do not have a means to remotely indicate fuse failure. Each circuit breaker 18 forms a portion of a detection circuit 24 as illustrated in Figure 2. The detection circuit 24 includes a power source 12 and the circuit breaker 18 connected in series with a resistor 26, and a fuse 28 connected in parallel with the circuit breaker 18 and the resistor 26. Due to the finite impedance of the fuse 28, load current is shared between the fuse 28 and the parallel resistor 26 and circuit breaker 18 in combination. The resistor 26 impedance is selected so that the series impedance of the resistor 26 and circuit breaker 18 in combination limits the circuit breaker current to an amount less than the trip limit of the circuit breaker 18 at the fuse 28 failure current. The resistor 26 is sized to prevent excessive current from flowing through the circuit breaker 18 during normal operation that would trip the circuit breaker 18. In this example, the fuse 28 amperage rating is greater than the circuit breaker 18 amperage rating by a factor of approximately ten. In another example, the fuse 28 amperage rating is greater than the circuit breaker 18 rating by a factor of approximately one hundred.

When the detection circuit 24 experiences an overload or short circuit, the resistor 26 initially forces the overload current through the fuse 28, causing it to fail and subsequently, the overload current will flow through the circuit breaker 18. Because the circuit breaker 18 amperage rating is much lower than the amperage rating of the fuse 28, the circuit breaker 18 will trip when the full load current travels through the circuit breaker 18. When the circuit breaker 18 trips, the circuit breaker position sensor 20 (shown in FIG. 1) detects the tripped circuit breaker 18 and communicates the row and column location of the tripped circuit breaker 18 to the remote location 30. Remotely communicating the tripped breaker 18 is particularly beneficial when the power panel 14 is not easily accessible and the status of the fuse 28 could determine how to operate the piece of equipment with which the power system 10 is associated. Additionally, locating the circuit breaker 18 and the resistor 26 in parallel with the fuse 28 allows for simulation of a blown fuse 28 by manually tripping the circuit breaker 18.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. A blown fuse detector comprising:
a fuse (28); and
a resistor (26) in series with a circuit breaker (18), wherein the circuit breaker (18) and the resistor (26) are in parallel with the fuse (28) and the circuit breaker (18) is configured to trip when the fuse (28) is in a blown state.

2. The detector of claim 1, wherein an amperage rating of the fuse (28) is greater than an amperage rating of the circuit breaker (18).

3. The detector of claim 2, wherein the amperage rating of the fuse (28) is greater than the amperage rating of the circuit breaker (18) by approximately a factor of ten.

4. The detector of claim 2, wherein the amperage rating of the fuse (28) is greater than the amperage rating of the circuit breaker (18) by approximately a factor of one hundred.

5. The detector of claim 1, including a circuit breaker positioning sensor in communication with the circuit breaker (18).

6. The detector of claim 5, wherein the circuit breaker positioning sensor is capable of communicating the condition of the circuit breaker (18) to a remote location.

7. The detector of claim 1, wherein the resistor (26) is sized to prevent the circuit breaker (18) from tripping during normal operating currents.

8. A method of assembling a blown fuse detector comprising:
positioning a circuit breaker (18) in series with a resistor (26); and
positioning a fuse (28) in parallel with the circuit breaker (18) and the resistor (26).

9. The method of claim 8, wherein an amperage rating of the fuse (28) is greater than an amperage rating of the circuit breaker (18).

10. The method of claim 8, wherein the amperage rating of the fuse (28) is greater than the amperage rating of the circuit breaker (18) by approximately a factor of one hundred.

11. The method of claim 8, including a circuit breaker positioning sensor in communication with the circuit breaker (18).

12. The method of claim 11, wherein the circuit breaker positioning sensor is capable of communicating the condition of the circuit breaker (18) to a remote location.

13. The method of claim 8, wherein the resistor (26) is sized to prevent the circuit breaker (18) from tripping during normal operating currents.
